# EUROPEAN PATENT APPLICATION

(11) **EP 4 525 259 A1**
(43) Date of publication of application: **19.03.2025**
(21) Application number: 23907723.3
(22) Date of filing: 20.12.2023
(51) Int. Cl.: H02J 7/00, H05K 7/20

(54) **WATER-COOLED INTEGRATED CHARGER AND DISCHARGER**

(30) Priority: 22.12.2022 KR 20220181956; 04.05.2023 KR 20230058048
(71) Applicant: LG Energy Solution, Ltd., Seoul 07335 (KR)
(72) Inventor: KANG, Jung Nam, Daejeon 34122 (KR)
(74) Representative: Goddar, Heinz J.
(86) International application number: PCT/KR2023/021099
(87) International publication number: WO 2024/136440

(57) **Abstract**

The present disclosure relates to a water-cooled integrated charger and discharger, which provides a charger and discharger comprising: a charging and discharging jig configured to charge and discharge a battery; a water-cooled power supply part configured to supply a power source to the charging and discharging jig and configured to be cooled with water; and a chiller connected to the water-cooled power supply part through a water-supply pipe and a drainpipe, and configured to release heat energy generated from the water-cooled power supply part to an exterior environment.

## Description

### Cross-Reference to Related Applications

This application is a National Phase entry pursuant to 35 U.S.C. 371 of International Application No. PCT/KR2023/021099 filed on December 20, 2023, which claims priority to and the benefit of Korean Patent Application No. 10-2022-0181956 filed in the Korean Intellectual Property Office on December 22, 2022 and Korean Patent Application No. 10-2023-0058048 filed in the Korean Intellectual Property Office on May 4, 2023. The contents of the aforementioned applications are incorporated by reference herein in their entireties.

### Technical Field

The present disclosure relates to a water-cooled integrated charger and discharger. Also, the present disclosure relates to a water-cooled integrated charger and discharger by a method of preventing condensation in a power supply part and cooling a jig.

### Background Art

A battery activation process or the like charges and discharges a battery using a charger and discharger, but as a power supply part of the charger and discharger generates heat, an air-cooled structure using air was conventionally adopted to cool the power supply part, and for example, the power supply part was cooled using a heatsink and a cooling fan.

However, the existing air-cooled structure has the following problems. First, due to the existing air-cooled structure, exothermic heat of the power supply part is released into an internal (indoor) space. Second, due to the released heat, the temperature of the internal space rises, and accordingly, it is necessary to add air-conditioning equipment. Third, due to the heatsink for cooling the power supply part, it is difficult to reduce the size. Fourth, heat generation by lines is also a problem. Fifth, the equipment integration degree is lowered in the same area.

The background description provided herein is for the purpose of generally presenting context of the disclosure. Unless otherwise indicated herein, the materials described in this section are not prior art to the claims in this application and are not admitted to be prior art, or suggestions of the prior art, by inclusion in this section.

### Summary

Therefore, it is an object of some embodiments to provide a charger and discharger capable of preventing the temperature of the internal space from increasing due to heat generation of the power supply part and lines, and increasing facility integration degree by reducing the size.

It is another object of some embodiments to provide a charger and discharger capable of cooling the jig while preventing condensation in the water-cooled power supply part that may occur as the water-cooled structure is applied.

To achieve the above-described objects, the present disclosure provides a charger and discharger comprising: a charging and discharging jig configured to charge and discharge a battery; a water-cooled power supply part configured to supply power to the charging and discharging jig and adapted to be cooled with water; and a chiller connected to the water-cooled power supply part through a water-supply pipe and a drainpipe, and being configured to release heat energy generated from the water-cooled power supply part to an outside or exterior environment.

In certain embodiments, the water-cooled power supply part may comprise a first fan configured to supply internally cooled air to the charging and discharging jig.

In certain embodiments, the first fan may be situated adjacent to a cell tab of the battery and a gripper of the charging and discharging jig, and may be positioned to cool the cell tab and the gripper.

In certain embodiments, the water-cooled power supply part may be disposed above and below the charging and discharging jig, and the first fan may be disposed at a lower portion of an upper water-cooled power supply part and an upper portion of a lower water-cooled power supply part.

The charger and discharger according to certain embodiments may further comprise a temperature sensor configured to measure a temperature in a space where the charging and discharging jig is disposed, wherein a speed of the first fan may be adjusted depending on the temperature.

In certain embodiments, the charging and discharging jig may be equipped with a second fan disposed on a side surface.

The charger and discharger according to certain embodiments may further comprise a cooling column connected to the chiller through the water-supply pipe and the drainpipe.

In certain embodiments, the water-cooled power supply part may comprise a power-supply module and a cooling module, and the cooling module may be in contact with the power-supply module and may have a cooling water flow path therein.

In certain embodiments, a plurality of charging and discharging jigs and a plurality of water-cooled power supply parts may be disposed in multiple stages in at least one of a vertical direction and a horizontal direction.

In certain embodiments, a line connecting the charging and discharging jig and the water-cooled power supply part may have a length of 1.5 meters (m) or less.

According to certain embodiments, by constructing the water-cooled power supply part below the charging and discharging jig, it is possible to prevent the temperature increase of the internal space due to heat generation of the power supply part and the lines, and by reducing the size, it is possible to increase the equipment integration degree. Also, the heat of the power supply part is released to the outside, so that it can be easy to control the temperature of the internal space, and accordingly, it can have the effect of reducing the load on internal air conditioning equipment. In addition, the length of the line is reduced, so that the efficiency can increase, and the installation area of the equipment can decrease.

In addition, according to certain embodiments, by maintaining the temperature of the water-cooled power supply part constant through the fan, it is possible to prevent condensation in the water-cooled power supply, and by supplying air cooled in the power supply part to the jig, it is also possible to cool the jig.

### Brief Description of Drawings

The accompanying drawings illustrate a preferred embodiment of the present disclosure and together with the foregoing disclosure, serve to provide further understanding of the technical features of the present disclosure, and thus, the present disclosure is not construed as being limited to the drawings.
Figure 1 is a front view of an existing air-cooled charger and discharger.
Figure 2 is a front view of a water-cooled integrated charger and discharger according to certain embodiments.
Figure 3 is a partial plan view of a water-cooled integrated charger and discharger according to certain embodiments.
Figure 4 is a partial front view of a water-cooled integrated charger and discharger according to certain embodiments.
Figure 5 is an exploded front view of a water-cooled integrated charger and discharger according to certain embodiments.
Figure 6 is a side view of a positive electrode side of a water-cooled integrated charger and discharger according to certain embodiments.
Figure 7 is a side view of a negative electrode side of a water-cooled integrated charger and discharger according to certain embodiments.
Figure 8 is a front view of a water-cooled power supply part according to certain embodiments.
Figure 9 is a cross-sectional view of a cooling module according to certain embodiments.
Figure 10 is a front view of a water-cooled integrated charger and discharger including an external cooling column according to certain embodiments.
Figure 11 is a front view of a modular water-cooled integrated charger and discharger including a plurality of charging and discharging jigs and a plurality of water-cooled power supply parts disposed in multiple stages in the vertical direction and the horizontal direction according to certain embodiments.

### Detailed Description

Hereinafter, embodiments of this disclosure will be described in detail with reference to the accompanying drawings.

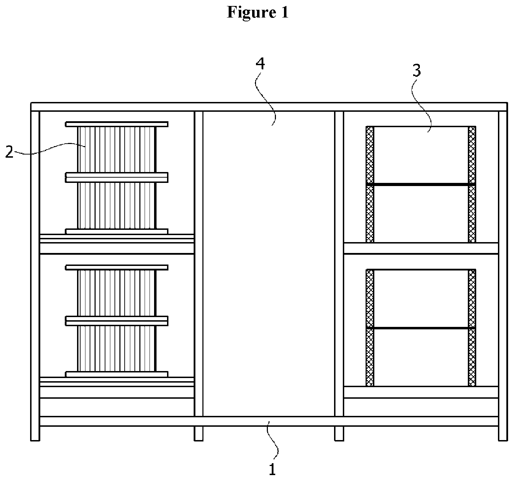

Referring to Figure 1, the existing air-cooled charger and discharger consists of a storage frame (1) divided into a plurality of spaces, one or more charging and discharging jigs (2) disposed on one side (left side) of the storage frame (1), one or more power supply parts (3) disposed on the other side (right side) of the storage frame (1), a maintenance passage (4) disposed in the center of the storage frame (1), one or more cooling fans (not shown) disposed on one or both sides of the power supply parts (3), and the like.

However, as described above, the existing air-cooled charger and discharger releases exothermic heat of the power supply parts (3) into the internal (indoor) space as it is due to its air-cooled structure. Also, due to the released heat, the temperature of the internal space increases, and accordingly, it is necessary to add air conditioning equipment. In addition, due to the heatsink for cooling the power supply parts (3), it is difficult to reduce its size.

Also, the charging and discharging jigs (2) and the power supply parts (3) are disposed separately and located far away on opposite sides, so that the line connecting the charging and discharging jigs (2) and the power supply parts (3) has a long length of approximately 8 m, and accordingly, exothermic heat due to the long line is also a problem. In addition, the charging and discharging jigs (2) and the power supply parts (3) are disposed separately on opposite sides, and the size of the power supply parts (3) themselves is large, and the maintenance passage (4) is also included, so that the equipment integration degree is lowered in the same area.

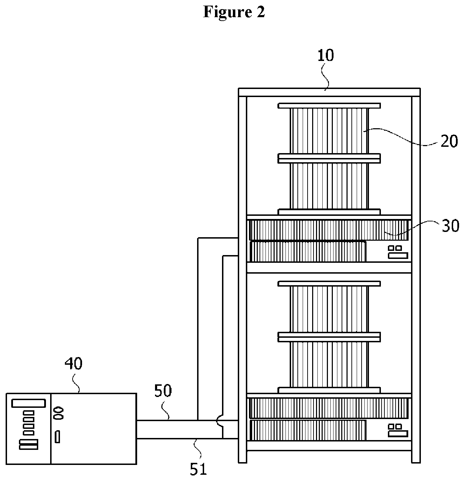

Referring to Figure 2, the water-cooled charger and discharger according to certain embodiments may consist of a storage frame (10), a charging and discharging jig (20), a water-cooled power supply part (30), a chiller (40), a water-supply pipe (50), a drainpipe (51), and the like. Most of these can be made of metal or the like.

The storage frame (10) is a pillar storing the charging and discharging jig (20) and the water-cooled power supply part (30) and supporting their weights, which may be divided into a plurality of spaces to have a plurality of storage spaces, wherein the charging and discharging jig (20) and the water-cooled power supply part (30) may be integrally stored in each storage space. The front surface and back surface of the storage frame (10), specifically the front surface and back surface of the storage space, may be opened. The storage frame (10) may be made of a metal such as iron.

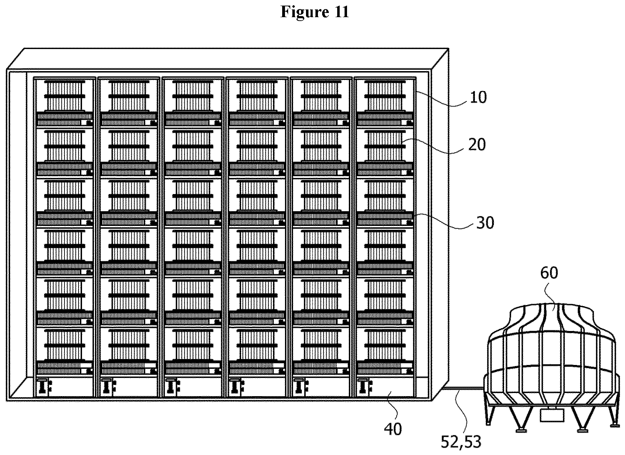

The size of each storage space is not particularly limited, but to reduce the installation area, it may have a size to the extent that it stores the charging and discharging jig (20) and the water-cooled power supply part (30) integrally, and leaves some free space. The number of storage spaces is not particularly limited, and for example, it may be two or more in the vertical direction as shown in Figure 2, and it may be 10±5 or so in the vertical direction and 6±3 or so in the horizontal direction as shown in Figure 11.

The charging and discharging jig (20) is for charging and discharging a battery, which may use a charging and discharging jig in the commonly used form, and may also use a charging and discharging jig capable of charging and discharging a plurality of batteries at once by mounting them. The charging and discharging jig (20) may be connected to the water-cooled power supply part (30) through the line to receive a power source.

The water-cooled power supply part (30) is for supplying a power source to the charging and discharging jig (20), which is characterized in that it is a water-cooled type cooled with water. The water-cooled power supply part (30) may be disposed above and/or below the charging and discharging jig (20). The water-cooled power supply part (30) and the charging and discharging jig (20) may be in direct contact with each other, or may be disposed to be in close contact or adjacent to each other with a horizontal frame (12) interposed therebetween, and this arrangement may be referred to as an integrated type.

In the water-cooled structure according to certain embodiments, the charging and discharging jig (20) and the water-cooled power supply part (30) are integrally stored into the storage frame (10) when compared to the existing air-cooled structure of Figure 1, so that the total installation area can be reduced to approximately 1/3 of the existing air-cooled structure. Also, the heatsink, and the like are unnecessary, so that the size of the power supply part (30) itself can also be reduced to approximately half relative to the existing air-cooled power supply part. In addition, the charging and discharging jig (20) and the water-cooled power supply part (30) are disposed to be in close contact or adjacent to each other, so that the length of the line connecting the charging and discharging jig (20) and the water-cooled power supply part (30) can be shortened from about 8 m conventionally to 1.5 m or less.

The chiller (40) is for releasing heat energy generated from the water-cooled power supply part (30) to the outside, particularly to an external cooling column, which may be equipped with typical refrigerant cycles and pumps, and the like to supply cooling water to the water-cooled power supply part (30). The chiller (40) may be connected to the water-cooled power supply part (30) through the water-supply pipe (50) and the drainpipe (51), but when the chiller (40) is connected to a plurality of water-cooled power supply parts (30), the water-supply pipe (50) and the drainpipe (51) may be branched into multiple numbers.

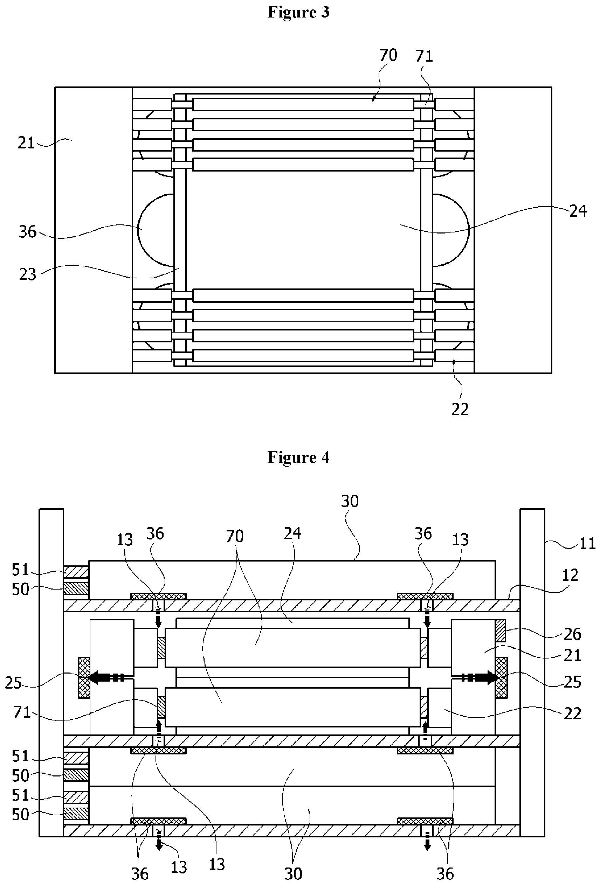

Referring to Figures 3 to 7, there is a possibility that upon heat dissipation through water cooling, condensation occurs in the water-cooled power supply part (30), but certain embodiments can be characterized by installing a first fan (36) on the water-cooled power supply part (30) for condensation prevention. The temperature can be maintained constant by circulating the internal air of the water-cooled power supply part (30) through the first fan (36). Specifically, the condensation can occur upon configuring the water-cooled power supply part (30), but external air is entered from the output (line) portion of the power supply part (30), and the fan (36) is installed at the upper portion and/or the lower portion of the power supply part (30) to create an air flow, whereby it is possible to prevent condensation.

Referring to Figures 4, 6, and 7, the storage frame (10) may be composed of a plurality of vertical frames (11) and a plurality of horizontal frames (12) to form a plurality of storage spaces. The vertical frame (11) is a facility outer pillar, which may be disposed at both terminals when viewed from the front. Referring to Figure 4, a plurality of through holes (13) may be formed in the horizontal frame (12), and the air cooled inside the water-cooled power supply part (30) may be moved into the charging and discharging jig (20) through these through holes (13). Each through hole (13) may be disposed at the location of each first fan (36). The size of the through hole (13) may be the same as or smaller than that of the first fan (36). The vertical frame (11) may have no separate through hole.

Referring to Figures 3 to 7, the charging and discharging jig (20) may be comprised of a jig block (21), a gripper (22), a tray support (23), a cell tray (24), a second fan (25), a temperature sensor (26), and the like. Referring to Figures 4 to 7, a plurality of charging and discharging jigs (20) may be laminated in multiple layers in one storage space.

The jig blocks (21) may be disposed at both terminal portions of the charging and discharging jigs (20), respectively, and may be formed in the form of a block.

The gripper (22) is for holding the battery cell (70) and supplying a power source to the battery cell (70), which may also be expressed as a clip. The battery cell (70) may be a pouch type battery cell. The grippers (22) may be disposed inside both jig blocks (21). The grippers (22) may be divided into a positive electrode gripper (22a) and a negative electrode gripper (22b) that are connected to a positive electrode cell tab (71a) and a negative electrode cell tab (71b), respectively.

The tray support (23) supports the cell tray (24), which may be disposed below the cell tray (24).

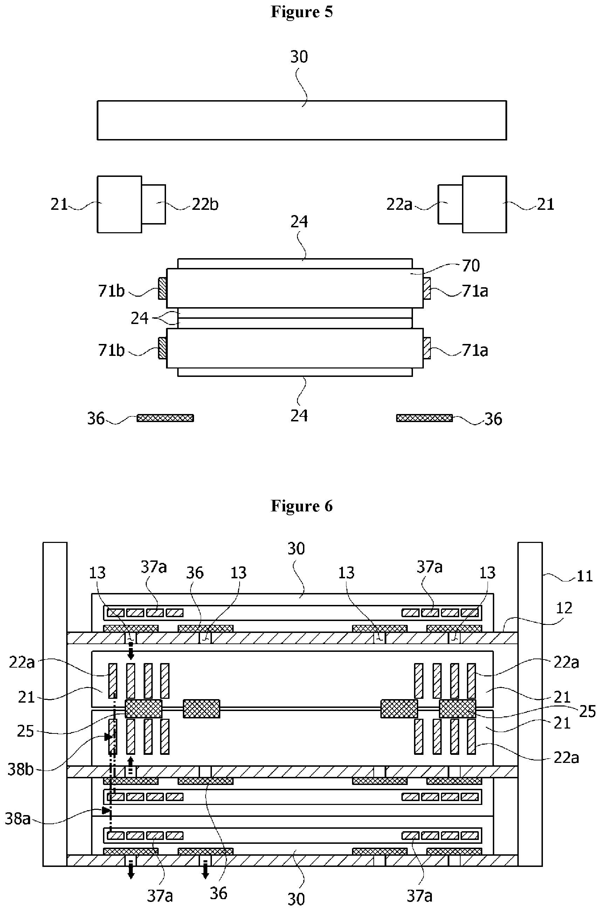

The cell tray (24) is a place where the battery cell (70) is disposed, which may be disposed at the upper portion and/or the lower portion of the battery cell (70). Referring to Figure 3, a plurality of battery cells (70) may be stood in the vertical direction at regular intervals on the cell tray (24) and disposed. Referring to Figure 5, and the like, the battery cell (70) may be equipped with a positive electrode cell tab (71a) and a negative electrode cell tab (71b).

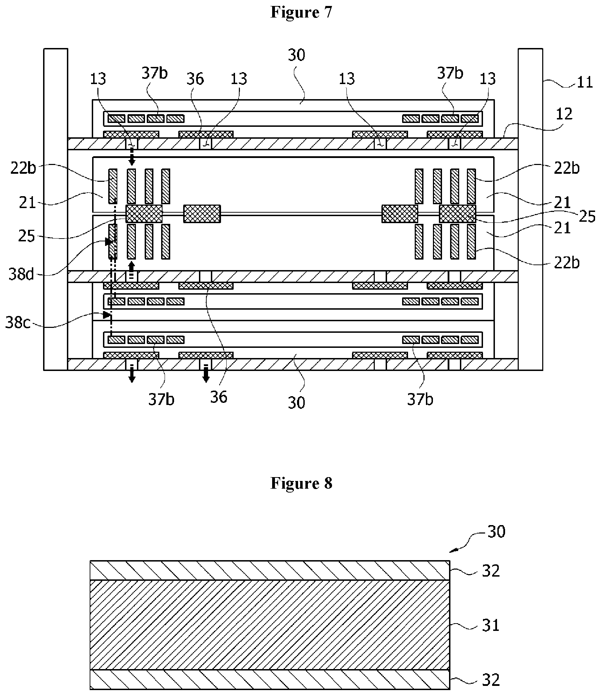

The second fan (25) is a cooling fan for suppressing the temperature increase inside the battery cell (70) by releasing exothermic heat of the cell tabs (71) to the outside, which may be disposed on the side surface of the charging and discharging jig (20), and preferably, may be disposed in multiple numbers on both side surfaces of the charging and discharging jigs (20). In addition, referring to Figures 6 and 7, a plurality of second fans (25) may be disposed from the front surface toward the back surface. When the plurality of charging and discharging jigs (20) is laminated in multiple layers in one storage space, the second fan (25) may be disposed between two adjacent charging and discharging jigs (20), and for example, as shown, the second fan (25) may be installed between first stage and second stage charging and discharging jigs (20).

The temperature sensor (26) is for measuring the temperature in the space where the charging and discharging jigs (20) are disposed, which may adjust and maintain the jig space temperature by measuring the space temperature in the jig and adjusting the speed of the first fan (36) depending on the temperature change. One or a plurality of temperature sensors (26) may be installed, for example, at an appropriate location of the jig (20) or the frame (10), and the like.

Referring to Figures 3 to 7, the water-cooled power supply part (30) may be equipped with first fans (36), output terminals (37a, 37b), lines (38a, 38b, 38c, 38d), and the like. Like the jig (20), a plurality of water-cooled power supply parts (30) may be laminated in multiple layers in one storage space. The external case of the water-cooled power supply part (30), and the like may be made of a metal such as aluminum. The water-cooled power supply part (30) may be in close contact with the horizontal frame (12) for cooling and air transmission, and the like. In addition, referring to Figure 4, a water-supply pipe (50) through which cold water is supplied from the chiller (40) and a drainpipe (51) through which hot water is discharged toward the chiller (40) may be connected to each power supply part (30).

The first fan (36) is a cooling fan for supplying air cooled inside the water-cooled power supply part (30) to the charging and discharging jig (20), wherein to this end, the power supply part (30) may comprise an empty space therein, the air in the empty space may be cooled through water cooling, and the cooled air may be released into the space on the jig (20) side through the fan (36).

The first fan (36) may be disposed to be adjacent to the cell tab (71) of the battery cell (70) and the gripper (22) of the charging and discharging jig (20), thereby cooling the cell tab (71) and the gripper (22). In this way, the space temperature of the jig (20) may be adjusted by supplying the cooled air of the power supply part (30) to the portions of the gripper (22) of the jig (20), and the cell tab (71), and the constant temperature may be maintained by measuring the jig space temperature using the sensor (26), and adjusting the speed of the fan (36).

Referring to Figure 4, and the like, the water-cooled power supply part (30) may be disposed above and below the charging and discharging jig (20), respectively, and the first fan (36) may be disposed at a lower portion of an upper water-cooled power supply part (30) and an upper portion of a lower water-cooled power supply part (30). For example, the first fan (36) may be disposed at both corner portions of the power supply part (30) when viewed from the front, and referring to Figures 6 and 7, a plurality of first fans may be disposed from the front to the back surface, but the location and number of first fans (36), and the like are not particularly limited.

The first fan (36) may create air flows up and down for condensation prevention of the power supply part (30). Specifically, external air enters the space where the output line of the power supply part (30) is connected, and the air flow is created using the fan (36) in the direction of the jig (20) to maintain the temperature of the space constant, whereby it is possible to prevent the condensation of the power supply part (30).

In addition, the first fan (36) may supply the air cooled in the power supply part (30) to the space of the jig (20), and the portions of the gripper (22) and the cell tab (71) to cool them. Upon charging and discharging the battery, the cell tab (71) portion has a characteristic that the temperature is relatively high due to contact resistance, and the like, but the fan (36) in the power supply part (30) faces the tab (71) portion, thereby being capable of cooling it. For example, based on the double-layer jig (20) illustrated in Figure 4, the fan (36) of the power supply part (30) disposed above may cool the tab (71) portion of the first stage jig (20), and the power supply part (30) disposed below may cool the tab (71) portion of the second stage jig (20) by installing the fan (36) in the reverse position relative to the lower power supply part.

Referring to Figure 4, the flow directions of the air cooled in the power supply part (30) are indicated by arrows, wherein the first fan (36) of the upper power supply part (30) may send air downward toward the jig (20), the first fan (36) of the lower power supply part (30) may send air upward toward the jig (20), and the second fan (25) disposed on both side surfaces of the jig (20) may send air in the left and right (horizontal) directions toward the vertical frame (11). The vertical frame (11) has no separate through hole, where exothermic heat (hot air) of the cell (70) may be discharged through the wall surface of the vertical frame (11). Finally, air may be discharged from the open front surface and back surface of the storage space.

The output terminal (37a, 37b) is a place where a power source is output, and referring to Figures 6 and 7, a plurality of output terminals may be disposed on both side surfaces of the power supply part (30). It may be divided into a positive electrode (+) output terminal (37a) in Figure 6 and a negative electrode (-) output terminal (37b) in Figure 7. An empty space may be formed in the output portion on the side surface of the power supply part (30).

The line (38a, 38b, 38c, 38d) is for electrically connecting the gripper (22) and the output terminals (37a, 37b), which may be divided into a first line (38a) connecting the first stage positive electrode gripper (22a) and the first stage positive electrode output terminal (37a), a second line (38b) connecting the second stage positive electrode gripper (22a) and the second stage positive electrode output terminal (37a), a third line (38c) connecting the first stage negative electrode gripper (22b) and the first stage negative electrode output terminal (37b), a fourth line (38d) connecting the second stage negative electrode gripper (22b) and the second stage negative electrode output terminal (37b), and the like, and may be composed of multiple numbers depending on the number of grippers (22) and output terminals (37a, 37b).

Referring to Figure 8, the water-cooled power supply part (30) may comprise a power-supply module (31) and a cooling module (32). The power-supply module (31) may have a hexahedral shape with a low height, and may comprise one or more power sources. The cooling module (32) may have a hexahedral shape with a lower height than that of the power-supply module (31), that is, a plate shape (cooling plate shape) with a thin thickness.

The power-supply module (31) and the cooling module (32) may be closely disposed while being in contact with each other for a cooling efficiency. Specifically, the cooling module (32) may be closely disposed while being in close contact with at least one of the six surfaces of the hexahedral-shaped power-supply module (31), preferably a plurality of surfaces including the upper surface and lower surface with large areas. In addition, for increase of the contact area, it is preferable that with respect to one surface of the power-supply module (31), the cooling module (32) is in contact with the entire area of the surface.

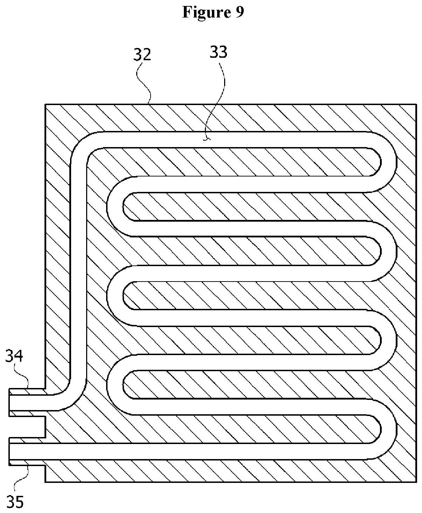

Referring to Figure 9, the cooling module (32) may have a cooling water flow path (33) therein through which the cooling water supplied from the chiller (40) flows. The flow path pattern of the cooling water flow path (33) is not particularly limited, but it may preferably have a zigzag pattern as illustrated in the drawing for residence time increase of the cooling water. Both terminal portions of the cooling water flow path (33) may be connected to a water-supply port (34) and a drain port (35), respectively, and the water-supply port (34) and the drain port (35) may be connected to the water-supply pipe (50) and the drainpipe (51), respectively.

The water-cooled power supply part (30) of Figures 8 and 9 is applicable to at least one of Figures 2 to 7, 10, and 11.

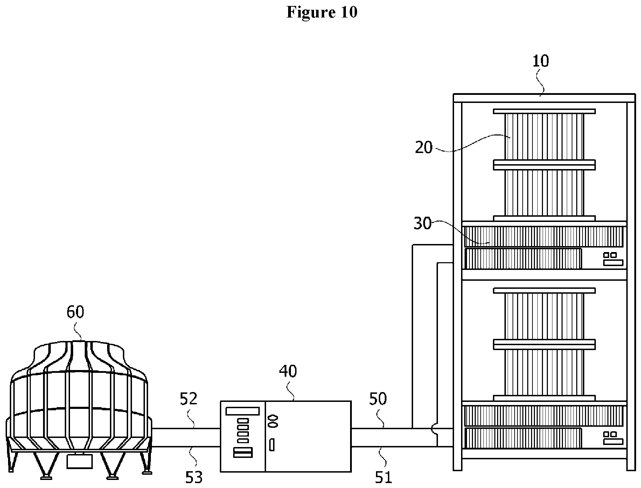

Referring to Figure 10, the charger and discharger according to certain embodiments may further comprise a cooling column (cooling tower) (60). The cooling column (60) is for finally releasing the heat energy generated from the water-cooled power supply part (30), which may be connected to the chiller (40) through the water-supply pipe (52) and the drainpipe (53), and may release the heat transferred from the chiller (40) to the outside. The cooling column (60) is preferably installed outside (outdoor) to prevent the temperature increase of the inside (indoor) space.

Referring to Figure 11, pluralities of charging and discharging jigs (20) and water-cooled power supply parts (30) may be disposed in multiple stages in at least one of the vertical direction and the horizontal direction. In the drawing, they are disposed in 10±5 rows, 6±3 columns, and the like, but the number of rows and columns is not limited thereto. At the bottom, one common chiller (40) is disposed in each column, whereby it may be connected to multiple water-cooled power supply parts (30) laminated in the vertical direction in the relevant column. Only one cooling column (60) is disposed outside (outdoor), whereby it may be connected to a plurality of chillers (40).

The configurations of Figures 10 and 11 may comprise at least one of the configurations of Figures 2 to 8.

Certain embodiments are intended to reduce space temperature deviation upon charging/discharging through the water-cooled structure, and to this end, by constructing the water-cooled power supply part below the charging and discharging jig part, and the like, and using the chiller, it is possible to release heat to the external space (cooling column). Also, the distance between the jig and the power supply part is short, so that the length of the line can be reduced from about 8 m conventionally to 1.5 m or less. In addition, when the power supply part has been made in a modular manner, it can be operated alone or in parallel, so that it is easy to expand capacity.

When certain embodiments of this disclosure are compared with the existing air-cooled structure, the size of the power supply part is reduced by water-cooled application, so that it can be disposed below the jig, and the like; the number of cooling fans for cooling the power supply part is reduced from about 24 conventionally to about 2 or so; the overall facility size is reduced; the line length is reduced from about 8 m conventionally to 1.5 m or less; the temperature increase of the jig space due to line heat generation is suppressed; heat is released to the external cooling column through the chiller, so that the indoor temperature increase is suppressed; and regardless of operation, the temperature of the power supply part can be adjusted to a constant temperature.

As described above, certain embodiments described herein have advantages that the heat generated in the power supply part is released to the external cooling column by applying the water-cooled chiller, upon operating the power supply part, the rapid temperature increase is suppressed by supplying cooling water at a constant temperature, the effect of internal space temperature increase due to heat generation of the power supply part upon charging/discharging operation is fundamentally eliminated, and the length of the line is shorter than that of the existing line, so that the influence caused by the line can be minimized even when the current capacity increases, and as exothermic heat from the power supply part is released to the outside, the deviation of internal space temperature in the future can be improved.

In addition, according to certain embodiments, by maintaining the temperature of the water-cooled power supply part constant through the fan, it is possible to prevent condensation in the water-cooled power supply, and by supplying air cooled in the power supply part to the jig, it is also possible to cool the jig.

### Explanation of Reference Numerals

1, 10: storage frame, 2, 20: charging and discharging jig, 3: power supply part, 4: maintenance passage, 11: vertical frame, 12: horizontal frame, 13: through hole, 21: jig block, 22, 22a, 22b: gripper, 23: tray support, 24: cell tray, 25: second fan, 26: temperature sensor, 30: water-cooled power supply part, 31: power-supply module, 32: cooling module, 33: cooling water flow path, 34: water-supply port, 35 : drain port, 36: first fan, 37a, 37b: output terminal, 38a, 38b, 38c, 38d: line, 40: chiller, 50, 52: water-supply pipe, 51, 53: drainpipe, 60: cooling column, 70: battery cell, 71, 71a, 71b: cell tab

## Claims

1. A charger and discharger comprising:
a charging and discharging jig configured to charge and discharge a battery;
a water-cooled power supply part configured to supply power to the charging and discharging jig and adapted to be cooled with water; and
a chiller connected to the water-cooled power supply part through a water-supply pipe and a drainpipe, wherein the chiller is configured to release heat energy generated from the water-cooled power supply part to an exterior environment.

2. The charger and discharger according to claim 1, wherein the water-cooled power supply part comprises a first fan that is configured to supply internally cooled air to the charging and discharging jig.

3. The charger and discharger according to claim 2, wherein the first fan is situated adjacent to a cell tab of the battery and a gripper of the charging and discharging jig, and is positioned to cool the cell tab and the gripper.

4. The charger and discharger according to claim 2, wherein the water-cooled power supply part is situated above and below the charging and discharging jig, and the first fan is disposed at a lower portion of an upper water-cooled power supply part and an upper portion of a lower water-cooled power supply part.

5. The charger and discharger according to claim 2, further comprising a temperature sensor configured to measure a temperature in a space where the charging and discharging jig is disposed, wherein a speed of the first fan is adjusted depending on the temperature.

6. The charger and discharger according to claim 2, wherein the charging and discharging jig is equipped with a second fan disposed on a side surface.

7. The charger and discharger according to claim 1, further comprising a cooling column connected to the chiller through the water-supply pipe and the drainpipe.

8. The charger and discharger according to claim 1, wherein the water-cooled power supply part comprises a power-supply module and a cooling module, the cooling module contacting the power-supply module and having a cooling water flow path therein.

9. The charger and discharger according to claim 1, wherein a plurality of charging and discharging jigs and a plurality of water-cooled power supply parts are disposed in multiple stages in at least one of a vertical direction and a horizontal direction.

10. The charger and discharger according to claim 1, wherein a line connecting the charging and discharging jig and the water-cooled power supply part has a length of 1.5 m or less.
